Europäisches Patentamt

(19) European Patent Office

Office européen des brevets

(11) **EP 1 118 960 B1**

(12) **FASCICULE DE BREVET EUROPEEN**

(45) Date de publication et mention de la délivrance du brevet:
**18.08.2004 Bulletin 2004/34**

(51) Int Cl.$^7$: **G06K 19/077**

(21) Numéro de dépôt: **01103498.0**

(22) Date de dépôt: **17.01.1997**

(54) **Module électronique sans contact pour carte ou étiquette**

Kontaktloser elektronischer Modul für eine Karte oder ein Etikett

Contactless electronic module for a card or a label

(84) Etats contractants désignés:
**AT BE CH DE DK ES FI FR GB IE IT LI LU MC NL SE**

(30) Priorité: **17.01.1996 FR 9600889**

(43) Date de publication de la demande:
**25.07.2001 Bulletin 2001/30**

(62) Numéro(s) de document de la (des) demande(s) initiale(s) en application de l'article 76 CBE:
**97901116.0 / 0 875 039**

(73) Titulaire: **GEMPLUS**
**13420 Gémenos (FR)**

(72) Inventeurs:
• **Leduc, Michel**
  **13530 Trets (FR)**
• **Martin, Philippe**
  **21200 Beaune (FR)**
• **Kalinowski, Richard**
  **13470 Carnoux en Provence (FR)**

(56) Documents cités:
| | |
|---|---|
| **EP-A- 0 376 062** | **EP-A- 0 521 778** |
| **EP-A- 0 620 537** | **DE-A- 4 311 493** |
| **DE-C- 3 721 822** | **DE-U- 8 909 783** |

**Description**

L'invention concerne le domaine des objets portables tels que étiquettes électroniques et les cartes à puce, pourvues d'un module électronique comprenant un microcircuit intégré.

L'invention concerne un procédé de fabrication de tels objets portables, défini dans les revendications.

On connaît déjà des objets portables sous la forme de cartes sans contact, au format ISO, qui sont destinées à la réalisation de diverses opérations, telles que par exemple, des transactions de paiement de prestations de transport, téléphoniques ou autres. Ces opérations s'effectuent grâce à un couplage à distance entre le module électronique de la carte et un appareil récepteur ou lecteur. Le couplage peut être réalisé en mode lecture seule ou en mode lecture/écriture.

En ce qui concerne les cartes, il est à noter que invention ne concerne pas uniquement les cartes ayant un fonctionnement exclusivement sans contact. Elle concerne également des cartes mixtes ou hybrides, qui ont la possibilité de fonctionner selon les deux modes: sans contact et par contact. Ces cartes mixtes sont destinées, par exemple, à des opérations du type télébilletique, dans lesquelles, après avoir été chargées en unités de valeur (unités monétaires, unités de paiement de prestations diverses), elle sont débitées à distance d'un certain nombre de ces unités de valeur lorsqu'elles passent au voisinage d'une borne de lecture: ce type de débit suppose un fonctionnement sans contact. Si nécessaire, ces cartes sont rechargées dans un distributeur adapté à cet effet.

Pour les besoins de la présente description, et à titre de simplification, on désignera aussi bien les cartes mixtes que les cartes sans contact, par la même terminologie de cartes sans contact.

On connaît par ailleurs des objets portables sous la forme d'étiquettes électroniques, généralement utilisées pour diverses opérations d'identification ou de suivi. Elles sont composées d'une part d'un module électronique à microcircuit, et d'autre part d'un support de ce module associé à une antenne bobinée fonctionnant à fréquence relativement basse (150 Khz) et de dimensions relativement grandes par rapport à celles du module.

Telles qu'ils sont réalisés actuellement, les objets portables en forme d'étiquettes électroniques comportent des antennes ayant un grand nombre de tours, souvent supérieur à 100, et leurs dimensions rendent leur manipulation délicate, notamment au cours des étapes de fabrication des étiquettes mettant en oeuvre la connexion par soudure de l'antenne au microcircuit du module.

De façon similaire, les objets portables en forme de cartes sans contact présentent également des inconvénients. Telles qu'elles sont réalisées actuellement, les cartes sans contact sont des objets portables de dimensions normalisées. Une norme usuelle mais nullement limitative pour la présente invention est celle dite ISO 7810 qui correspond à une carte de format standard de 85 mm de longueur, de 54 mm de largeur, et de 0,76 mm d'épaisseur.

Dans la plupart des cartes sans contact connues, chaque carte comporte un corps de carte réalisé par un assemblage de feuilles en matière plastique, et noyé dans cet assemblage, un module électronique comprenant un circuit intégré ou microcircuit encore appelé « puce », relié à l'aide de deux bornes de connexion, à une antenne bobinée du type self inductance. La puce comporte une mémoire, et peut dans certains cas comporter un microprocesseur. Les dimensions du module électronique sont sensiblement inférieures aux dimensions de la carte, le module étant en général positionné dans l'un des coins de la carte, puisque les contraintes mécaniques imposées au module du fait des flexions de la carte y sont moins élevées qu'au centre de la carte

. Dans certaines cartes sans contact connues cependant, un corps dé carte pourvu d'une cavité est prévu, et un module pourvu d'une bobine connectée à un circuit intégré est prévu, pour assurer un fonctionnement sans contact de la carte.

Le document DE4311493 décrit un module électronique comprenant un support. Mais il ne montre pas comment est effectuée le positionnement de la puce sur les spires de l'antenne. Ce document est considère comme l'art antérieur le plus proche qui reflète le préambule de la revendication 1. Dans ce document, l'antenne surmonte la puce et l'antenne est de forme dite "en l'air", enroulée et insérée sur la puce.

Le document DE3721822 décrit une carte à puce sans contact, apte à assurer un raccordement fiable entre un enroulement d'antenne et une puce. Cette carte ne comporte pas de module, puisque l'antenne est fabriquée sur la puce, en même temps que ses pistes supérieures.

Le document EP0376062 décrit un module électronique pour un objet portatif tel que carte à puce. Ce module comporte un enroulement d'antenne formé par un fil en l'air.

Le document EP0620537 décrit une étiquette électronique ou carte dans laquelle l'antenne comporte un enroulement sans noyau, avec unepluralité d'enroulements disposés suivant plusieurs couches superposées. Ce document ne décrit une antenne produite de manière à d'être plane, et entendu parallèlement au substrat sur ce dernier. L'antenne selon ce document est disposée sur la surface entière de la carte. Ce document propose de fixer facilement le module sur la carte, et de le relier à une antenne de taille sensiblement identique à celle de la carte. On connait aussi une carte à module où l'antenne se présente sous la forme d'une antenne à air bobinée, rapportée au-dessus de la puce, ce qui présente des difficultés de réalisation, de coût, de rendement, et de manque d'homogénéité des performances.

On connait également une carte à puce sans module, une antenne étant réalisée à même le semiconducteur en même temps que les pistes supérieures du circuit intégré de 4 x 6 à 6 x 8 mm, portant 20 petites spires.

Il en résulte que la surface utile de l'antenne est très faible, ce qui nuit à la portée. En outre, la carte selon ce document ne peut pas être fabriquée de façon très économique. En effet, on sait que la taille d'une pastille semiconductrice élémentaire est un des principaux facteurs de coût d'un circuit intégré produit en grandes quantités. Or dans ce document, la taille minimale du circuit intégré incorporant l'antenne est de l'ordre de 24 mm$^2$ au minimum, alors que les cartes sans contact bon marché utilisent en général des microcircuits dont la taille est très petite, de l'ordre de 1 mm$^2$.

On connaît encore d'autres procédés de réalisation de cartes sans contact, tels que ceux décrits dans les demandes de brevet français de la même demanderesse, déposées sous les numéros 95 400305.9, 95 400365.3, et 95 400790.2. Ces demandes de brevet ont en commun de décrire une carte sans contact pourvue d'une antenne sensiblement de la taille de la carte, connectée à un micromodule portant la puce.

Une telle antenne présente l'avantage d'une portée relativement élevée pour un champ magnétique de lecture ou d'écriture donné. En effet, la relation qui lie la force électromotrice E apparaissant aux bornes de l'antenne de réception lorsqu'elle coupe un champ électromagnétique est du type suivant:

$$(1) \qquad E_r = L_e \cdot (K_e \cdot S_e \cdot N_e) \cdot (K_r \cdot S_r \cdot N_r)/D^3$$

où K est une constante, S désigne la surface d'une spire moyenne d'antenne, N désigne le nombre de spires qui sont enroulées pour former l'antenne, les indices e et r représentant respectivement les côtés émission et réception, et D désigne la distance de lecture, c'est-à-dire la distance entre l'antenne de la carte, et l'antenne du lecteur extérieur.

Or, afin de faire fonctionner les circuits de la puce de la carte pour initialiser et effectuer une opération de lecture, la tension $E_r$ doit dépasser un certain seuil, qui est en général de l'ordre de 3 Volts.

On voit donc que pour une distance de lecture ou d'écriture D donnée que l'on cherche à atteindre avec la carte sans contact, il faut augmenter la surface de la spire moyenne et/ou le nombre N de spires de l'antenne, du côté lecture et/ou écriture.

L'efficacité de l'antenne sera conditionnée, à la fréquence retenue pour la lecture ou l'écriture, par le coefficient de surtension de la bobine d'antenne, qui est donné par l'expression:

$$(2) \qquad Q = L\omega/R$$

où L est l'inductance de la bobine, qui augmente avec le diamètre de la bobine et le nombre de tours, $\omega = 2\pi f$ où f désigne la fréquence de lecture, qui est figée pour une application donnée, et R désigne la résistance électrique de la bobine d'antenne, qui est proportionnelle à la longueur du fil qui la constitue.

Les grandeurs L et R ayant des influences contraires sur l'efficacité de l'antenne, elles ont tendance à se compenser, de sorte que le véritable facteur d'efficacité de l'antenne est surtout lié à la surface totale S.N de l'antenne.

Or pour une dimension de bobine planaire donnée, le nombre N de spires est limité par la largeur d'une spire et par l'intervalle entre deux spires, qui dépendent de la technologie de réalisation.

On voit donc que, toutes choses étant égales par ailleurs, la tendance naturelle pour obtenir une bonne antenne pour carte sans contact, et qui a été largement utilisée dans la pratique, consiste à utiliser sur la carte sans contact une antenne dont la taille de chaque spire se rapproche autant que possible de la surface de la carte. C'est pourquoi les cartes sans contact commercialisées comportent une antenne intégrée dans le corps de carte, au voisinage de la périphérie de celui-ci.

Mais, comme l'expérience de la fabrication de telles cartes sans contact l'a montré, ce choix entraîne également un certain nombre d'inconvénients.

En effet, la manipulation d'une antenne de cette taille en vue de son intégration dans la carte et de son raccordement électrique au module électronique pose de sérieux problèmes techniques (comme d'ailleurs dans le cas précité des étiquettes électroniques).

En effet, malgré les techniques utilisées, l'assemblage de la carte et de l'antenne reste souvent complexe et coûteux, puisqu'il faut raccorder le module électronique et la bobine d'antenne avec des moyens difficiles à automatiser. Ensuite, l'assemblage subit une lamination, qui est un procédé coûteux nécessitant l'adjonction de résine pour pouvoir noyer la bobine et le module dans la carte de telle manière qu'ils n'apparaissent pas à la surface de la carte et ne déforment pas les feuilles supérieures et inférieures utilisées pour la colamination.

En outre, la complexité du procédé ne permet pas l'obtention de rendements comparables à ceux obtenus lors de la fabrication des cartes à contact. Ceci est d'autant plus vrai lorsqu'on intègre les contraintes requises par certains types d'impression de la carte, et par la présence éventuelle d'une piste magnétique ou d'un embossage. En effet, pour certains types d'impression de la carte, ou pour la réalisation d'une bande magnétique sur la carte, celle-ci doit présenter une planéité quasi-parfaite, avec des défauts inférieurs à 6 μm. En cas d'embossage, il faut choisir des matériaux compatibles avec le procédé de fabrication de la carte, et l'antenne doit notamment laisser libre la zone prévue pour l'embossage, faute de quoi elle serait abîmée lors de l'embossage.

Compte tenu de l'ensemble des inconvénients liés aux modes actuels de fabrication de cartes sans contact et d'étiquettes électroniques, qui se traduisent principalement par un coût de fabrication élevé, les ingénieurs de la demanderesse se sont donnés pour objectif de proposer des procédés nouveaux de fabrication de cartes et d'étiquettes sans contact, susceptibles d'éviter l'ensemble des inconvénients cités.

Plus précisément, le but de la présente invention est de proposer des moyens peu coûteux aptes à être utilisés lors de la fabrication d'objets portables du type cartes à puce et/ou d'étiquettes électroniques.

Un autre but de l'invention est de fournir des procédés de fabrication de cartes et d'étiquettes sans contact, de faible coût, permettant une fabrication fiable et de qualité à l'aide de machines automatisées.

Un autre but de l'invention est de proposer un procédé de fabrication permettant d'obtenir des cartes sans contact parfaitement planes.

Un but supplémentaire de l'invention est de proposer un procédé de fabrication de cartes sans contact, qui soit compatible avec toutes les étapes subséquentes à l'assemblage du corps de carte et de l'antenne, et notamment avec l'impression offset des cartes, l'embossage de la carte, ou le dépôt d'une piste magnétique.

A cet effet, l'invention est définie dans les revendications.

L'invention prévoit d'utiliser pour la fabrication d'objets portables les chaînes de fabrication de cartes sans contact.

L'invention sera mieux comprise en se référant à la description suivante faite à titre d'exemple non limitatif et aux dessins ci-annexés, dans lesquels:

- la figure 1 représente une carte sans contact selon l'état de la technique;
- la figure 2 représente une carte sans contact selon l'invention;
- la figure 3 représente une bande utilisée pour la fabrication en continu de modules électroniques selon l'invention, destinés à des cartes sans contact ou à des étiquettes électroniques selon l'invention, ainsi qu'une carte destinée à recevoir le module;
- les figures 4A à 4G représentent plusieurs variantes de réalisation d'un module électronique selon l'invention, apte ou destiné à être incorporé dans le corps d'une carte sans contact ou dans une étiquette électronique;
- les figures 5A à 5D représentent en vue en coupe plusieurs variantes de réalisation d'un module électronique pourvu d'une antenne, selon l'invention;
- la figure 6 représente en coupe un module pour carte hybride à contact et sans contact.
- la figure 7 représente les étapes d'un procédé de fabrication d'une variante d'étiquette électronique utilisant le module électronique selon l'invention.

Des éléments similaires sont désignés par les mêmes numéros de référence dans l'ensemble des figures.

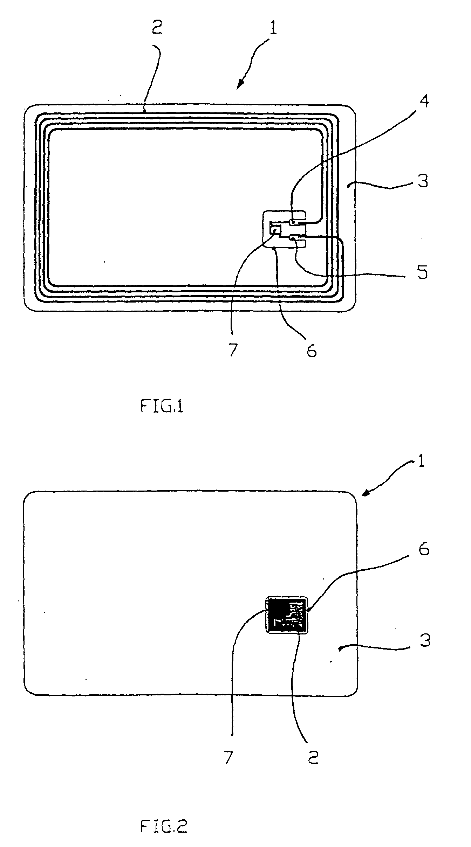

On se réfère à la figure 1 montrant de façon schématique et en plan une carte sans contact 1 du type de celles effectivement commercialisées. Comme on le voit, une antenne 2 sous la forme d'une bobine de grande dimension, légèrement inférieure à la dimension de la carte, est intégrée dans le corps de carte 3, et deux extrémités de la bobine d'antenne 2 sont connectées à des contacts d'alimentation 4,5 d'un module électronique 6 portant un microcircuit intégré 7 encore appelé une puce.

La bobine est représentée à l'échelle, sauf en ce qui concerne le nombre de spires, seules quatre spires ayant été représentées. Pour assembler une telle bobine 2 avec le corps de carte 3, il est nécessaire d'effectuer des opérations de laminage ou d'injection complexes et coûteuses, avec les inconvénients mentionnés précédemment. Une telle antenne permet de lire les informations de la carte, à partir d'une distance de 70 mm, pour une fréquence utilisée de quelques Mhz.

A la différence de la carte de la figure 1, le principe général sous-jacent à l'invention consiste à éliminer les antennes de grande taille actuellement utilisées pour les cartes sans contact, afin de supprimer les inconvénients mentionnés plus haut. L'invention cherche également à utiliser, pour atteindre les objectifs de fiabilité et de faible coût de fabrication visés, certains principes et les chaînes de fabrication utilisés lors de la fabrication de cartes à contact, cette fabrication étant maintenant bien maîtrisée et permettant d'obtenir des coûts de fabrication faibles.

La solution proposée est représentée de façon schématique sur la carte 1 de la figure 2. Elle consiste à utiliser un module particulier 6 de carte à puce combinant sur un même support de faibles dimensions, les fonctions électroniques des modules classiques à puce, et la fonction d'antenne d'émission/réception pour la transmission sans contact d'informations entre la carte et un dispositif de lecture/écriture extérieur (non représenté).

Le module 6 présente des dimensions compatibles avec les procédés de réalisation connus et utilisés pour fabriquer les cartes à contact, à la fois dans le sens de l'épaisseur et en plan, dans le sens de la longueur et de la largeur du module.

Bien entendu, pour qu'un module pourvu d'une antenne soit réalisable, il faut que, à l'inverse des enseignements de l'état de la technique, l'antenne soit obtenue avec des dimensions compatibles avec celles du module, tout en conservant un nombre de spires assurant la possibilité d'une transmission électromagnétique à une distance suffisante, de l'ordre de quelques centimètres. A cet effet, l'antenne est réalisée sous la forme d'une spirale formée d'un ensemble de spires situées directement sur le substrat de support et sensiblement dans le même plan, ce qui exclut les bobines à air enseignées par certains documents de l'état de la technique cité plus haut.

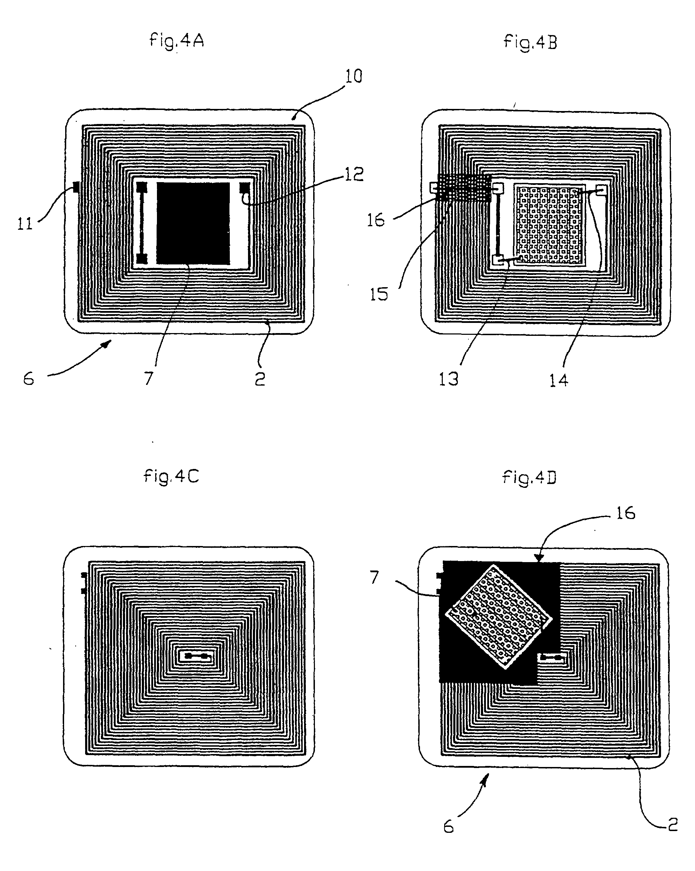

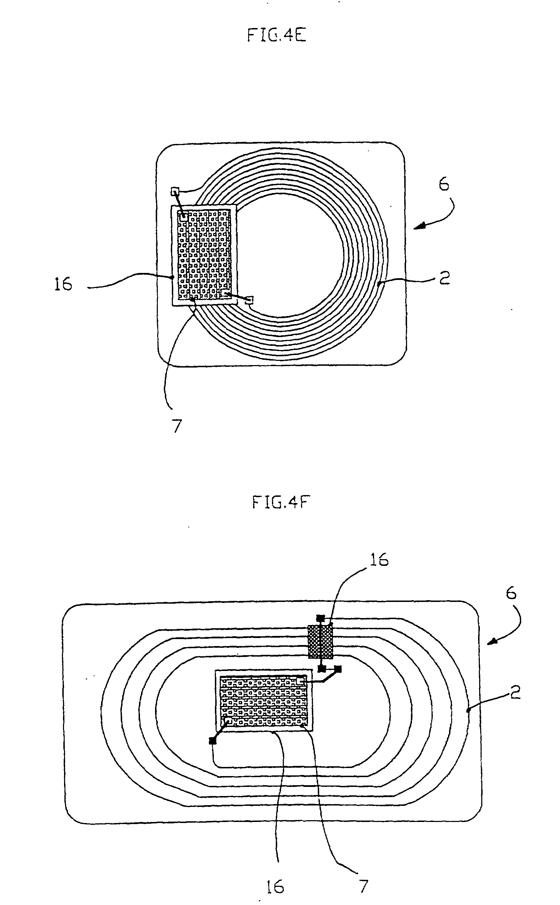

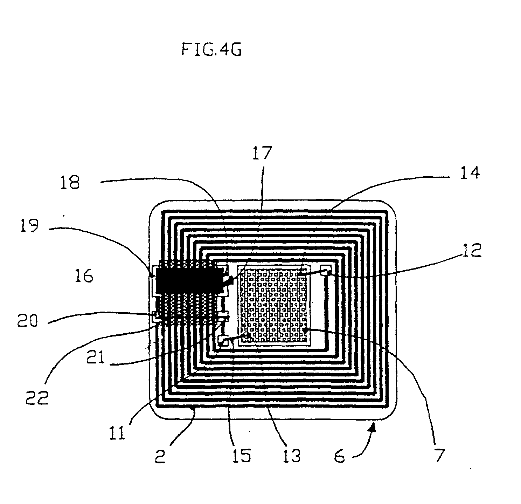

Afin de s'adapter au mieux à la forme du module et à la surface disponible, l'antenne peut avoir une spire extérieure de forme sensiblement carrée, rectangulaire, circulaire ou ovale, ou toute autre forme appropriée. Les deux extrémités de l'antenne sont connectées à des bornes d'alimentation d'un circuit intégré, notamment une mémoire et/ou un microprocesseur, situé(e) également sur le module, comme schématisé en 7 sur la figure 2, mais représenté plus en détail dans les figures 4 à 6.

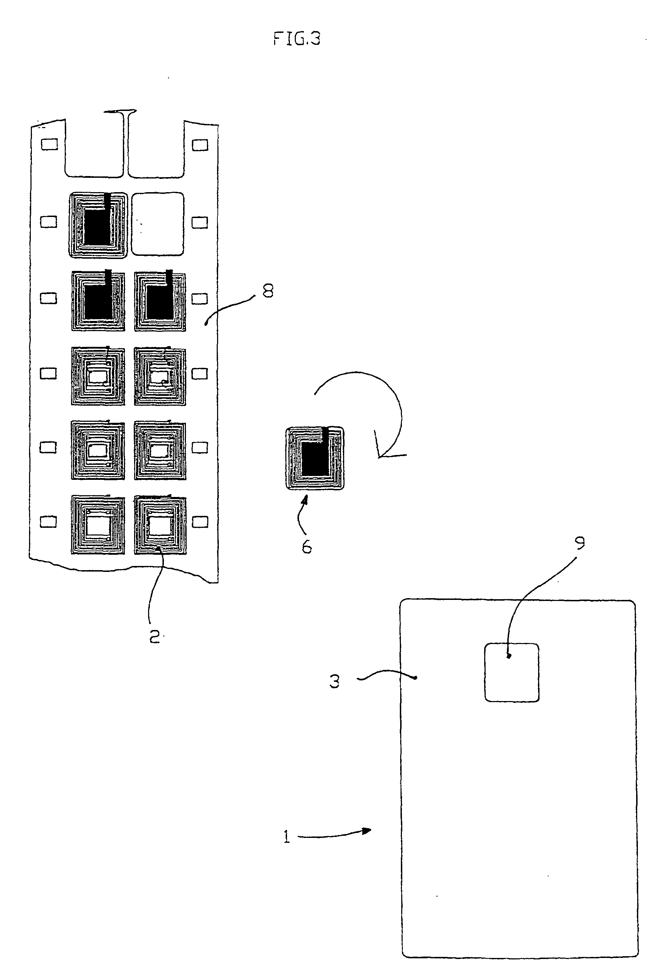

On se réfère à la figure 3 illustrant la séparation d'un module électronique 6 selon l'invention, à partir d'une bande 8 comportant une pluralité de modules 6 disposés par exemple selon deux rangées. La fabrication de modules électroniques classiques sur de telles bandes est bien connue en elle-même dans le domaine de la fabrication de cartes à contact, et ne sera de ce fait pas décrite davantage.

Un module 6 selon l'invention, par exemple du type comportant un circuit intégré 7 « à cheval » sur les spires d'une antenne 2 en forme de spirale carrée, est détaché de la bande 8 par un procédé de découpe, par exemple une découpe mécanique. Le module découpé est prélevé par des moyens automatiques non représentés mais connus, et amené, de préférence à l'envers (circuit intégré et antenne tournés vers le fond de l'ouverture du corps de carte) en face d'une ouverture borgne 9 aménagée dans le corps de carte 3 d'une carte à puce 1 sans contact. La fixation du module 6 dans l'ouverture 9 prévue est faite par collage, soudure, ou tout autre moyen approprié.

Il en résulte une carte sans contact conforme à l'invention, pourvue d'une antenne 2 localisée au niveau du module électronique 6, et dont la fabrication se réduit principalement aux étapes qui viennent d'êtres décrites, suivies bien entendu le cas échéant d'étapes d'impression et de personnalisation classiques.

Les figures 4A à 4G représentent de manière plus détaillée plusieurs variantes de modules destinés à être encartés pour fabriquer des cartes sans contact, ou encore intégrés dans un support de forme différente de la carte, par exemple pour fabriquer des étiquettes électroniques.

Un module 6 est composé d'un substrat de support 10 traditionnel (en film relativement flexible, en mylar, epoxy ou capton ) sur lequel est reporté, non pas une bobine, mais un motif d'antenne 2, qui peut être réalisé de plusieurs manières, comme expliqué plus loin. L'antenne 2 est par exemple réalisée par emboutissage à partir d'une feuille en cuivre, suivi d'un assemblage de la feuille emboutie avec le substrat de support. Le substrat de support 10 et l'antenne 2 sont le cas échéant assemblés de manière précise, en utilisant les moyens d'entraînement et de positionnement connus du substrat.

L'antenne 2 peut aussi être obtenue par gravure photochimique du motif d'antenne, ou par dépôt de matière métallique sur un film flexible formant le substrat 10. Le choix du substrat de support 10 approprié a des conséquences sur l'épaisseur du module, et dépend principalement de l'utilisation visée pour le module. Ce choix est entièrement à la portée de l'homme de métier.

Dans une variante proposée pour le module électronique 6, l'antenne 2 est constituée par une piste de cuivre de l'ordre de 15 µm à 70 µm d'épaisseur, réalisée en spirale, avec une distance entre spires de même grandeur. Les extrémités 11,12 de cette spirale sont de préférence élargies de façon à constituer des plots de contact pour la liaison avec le microcircuit 7.

Plusieurs variantes de positionnement respectif du microcircuit et de l'antenne sont prévus. Dans un premier mode de réalisation pratique et peu encombrant du module 6 (figure 4A), la puce 7 est collée au centre de l'antenne 2. En figure 4B, on a également représenté des fils conducteurs de liaison 13,14 pour relier une borne respective de la puce 7 à une extrémité respective correspondante 11,12 de l'antenne. Pour ce faire, il est nécessaire de passer un fil 15 au-dessus des pistes de l'antenne. A cet effet, un isolant 16 est au préalable déposé, notamment par sérigraphie, entre la zone correspondante des pistes, et le fil de liaison 15.

Dans un autre mode de réalisation du module 6 (figure 4C), l'antenne 2 occupe tout un côté du module et est dépourvue d'espace libre en son centre. Dans ce cas, l'invention prévoit de coller le microcircuit 7 soit sur la face du module dépourvue d'antenne, soit sur la même face que l'antenne (figure 4D), après interposition d'un isolant (partie sombre 16) entre l'antenne 2 et le microcircuit 7.

En figure 4E est représentée une variante de module électronique 6, dans laquelle l'antenne 2 a la forme d'une spirale circulaire, le microcircuit 7 étant positionné au-dessus du plan des spires, avec interposition d'un isolant 16. Cette configuration permet de minimiser la longueur des fils de connexion entre l'antenne et le microcircuit.

En figure 4F est représentée une variante supplémentaire du module 6 selon l'invention, particulièrement adaptée dans les cas où un module oblong ou rectangulaire est nécessaire. Dans ce cas, le motif d'antenne 2 a une forme de spirale sensiblement oblongue, le microcircuit 7 est de préférence positionné au centre de l'antenne, et des connexions entre les bornes du microcircuit et les plots de la bobine sont réalisés comme décrit en liaison avec la figure 4B.

Il est à noter que la connexion entre les plots de la puce et les bornes de contact de l'antenne peut être réalisée en utilisant une technique conventionnelle de connexion de fils conducteurs, comme par exemple la liaison dite par « bonding » consistant en des fils conducteurs soudés entre un plot du microcircuit et une borne respective de l'antenne, ou encore en utilisant la technique dite de « flip-chip » consistant à reporter le microcircuit sur le substrat de module 10, en ayant la face portant l'antenne et le microcircuit collée sur le substrat. La protection par résine des contacts est ensuite effectuée en utilisant les procédés traditionnels de réalisation des cartes à puce à contacts.

La figure 4G représente en vue plus détaillée un module électronique 6 selon l'invention, sur lequel un condensateur d'accord 17 a été réalisé à cheval sur les spires d'antenne, par dépôt au-dessus d'une couche d'isolant 16 (partie grisée). Afin de connecter le condensateur en parallèle entre les bornes 11,12 de l'antenne 2 et les plots 13,14 du microcircuit, une borne 18 du condensateur 17 est reliée à la borne 12 et au plot 14, et l'autre borne 19 du condensateur 17 est reliée à la borne 11 et au plot 13, par l'intermédiaire de plots intermédiaires 20,21 reliés par une connexion intermédiaire 22 située entre les plots intermédiaires 20,21 et réalisée au-dessus de la couche isolante 16, de façon à ne pas court-circuiter les spires de l'antenne.

Bien entendu, d'autres dispositions du condensateur d'accord 17 sont possibles. Il sera en particulier possible de l'intégrer sur le microcircuit 7 lui-même, au stade de conception de celui-ci, ce qui économisera des étapes de fabrication du module 6.

Le motif d'antenne est déterminé pour permettre un fonctionnement à haute fréquence, de l'ordre du Mhz, la valeur du condensateur d'accord 17 étant choisie pour obtenir une fréquence déterminée de fonctionnement de l'antenne 2 située dans une plage de hautes fréquences de l'ordre de 1 Mhz à 450 Mhz. Dans un exemple de réalisation permettant d'obtenir une fréquence de fonctionnement usuelle d'environ 13,56 Mhz, le condensateur d'accord 17 a une valeur de l'ordre de 12 à 180 picoFarad. Dans une autre variante permettant un fonctionnement à 8,2 Mhz, le condensateur d'accord à une valeur de l'ordre de 30 à 500 picoFarad.

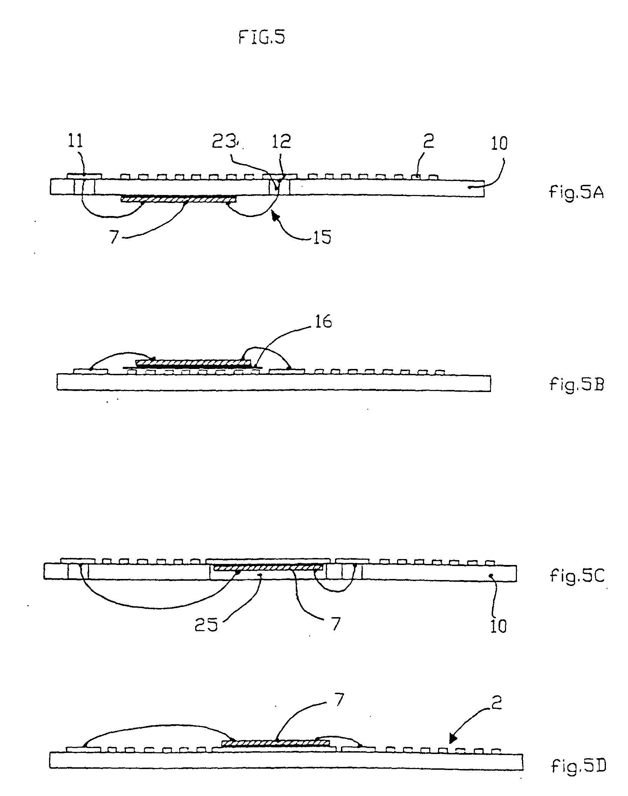

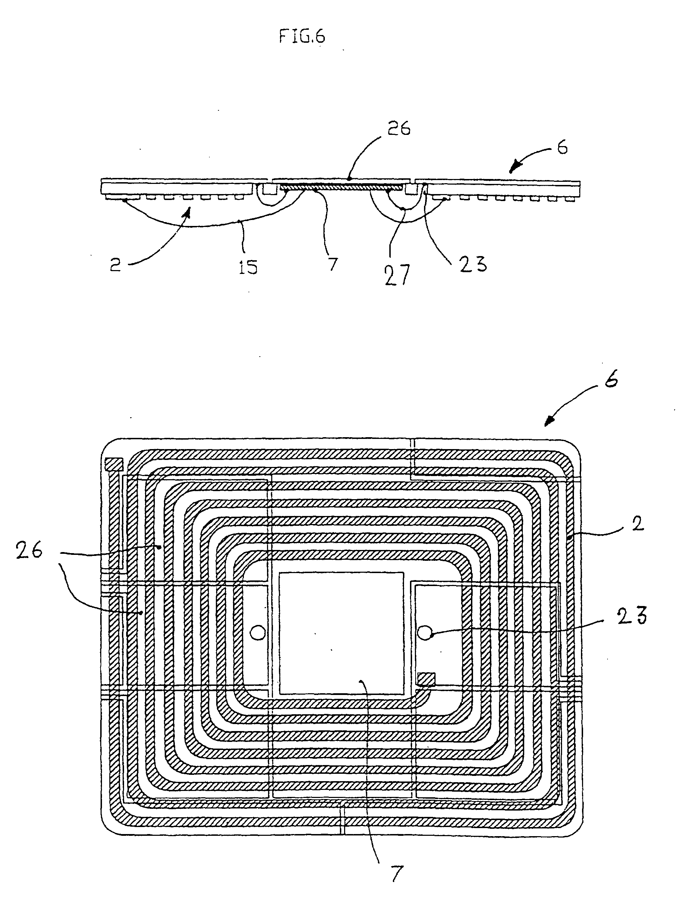

Les figures 5 et 6 montrent divers modes de réalisation du module 6, représenté en coupe. En figure 5, on a utilisé comme antenne une grille métallique découpée puis collée sur un substrat de support 10. Le découpage mécanique d'une antenne spiralée convient pour des largeurs de pistes pas trop fines, de l'ordre de 300 µm au minimum à l'heure actuelle.

En figure 5A, le microcircuit 7 et l'antenne 2 sont situés sur les deux faces opposées du substrat de support 10 du module, les bornes de contact 11,12 de l'antenne 2 étant connectés à des plots du microcircuit (non représentés) par l'intermédiaire de fils de connexion 15 amenés à travers des puits 23 réalisés dans le support 10.

En figure 5B, le microcircuit 7 est du même côté que l'antenne 2, et disposé au-dessus de ses spires avec interposition d'un isolant 16. En figure 5C, le microcircuit 7 est disposé dans une cavité 25 aménagée à cet effet dans le support 10 du module, ce qui permet de diminuer l'épaisseur de l'ensemble du module 6. En figure 5D, le microcircuit 7 est simplement collé au centre de l'antenne 2, comme montré également en figures 4A,4B. Dans tous les cas, l'antenne est entièrement située sur le substrat de support 10 faisant partie du module, et le microcircuit est <u>rapporté</u> sur cette structure de substrat et d'antenne.

Il est à noter que pour réduire encore l'épaisseur du module 6, il est possible d'utiliser pour l'antenne 2 une grille gravée dans ou déposée par métallisation ou autrement sur un substrat de support 10 approprié, au lieu d'une grille métallique découpée.

On se réfère maintenant à la figure 6, dans laquelle a été représentée en coupe et en vue de dessus une autre forme de réalisation du module électronique 6, afin d'obtenir un module hybride à contact et sans contact, particulièrement adapté à la fabrication de cartes hybrides. Dans ce module, le microcircuit 7 et l'antenne sont disposés sur une première face du substrat de support 10 du module, comme déjà décrit en liaison avec la figure 5. En outre, des contacts 26 usuels identiques aux contacts des cartes à contact sont connectés à des plots correspondants du microcircuit par des fils conducteurs 27. Le microcircuit dialoguera avec l'extérieur en utilisant les contacts 26 ou l'antenne 2, en fonction du signal extérieur appliqué. L'ensemble des composants utiles pour le fonctionnement de la carte hybride, y compris l'antenne 2, est donc disposé sur un module hybride 6 de faibles dimensions, apte à être encarté, c'est-à-dire incorporé dans un corps de carte.

De façon avantageuse, deux modules 6 de l'un des types décrits plus haut pourront être réalisés côte à côte dans la largeur d'un film 10 standard (soit 35 mm), mais d'autres arrangements des modules 6 sur une bande de support 8 sont compris dans le cadre de l'invention. Chaque module 6 pourra être ensuite reporté sur un corps de carte 3 au format ISO standard en utilisant le procédé traditionnel de report des modules dans les corps de cartes, tel qu'utilisé pour la fabrication de cartes à contacts.

Alternativement, les modules 6 peuvent être utilisés pour la fabrication d'étiquettes électroniques, du type de celles utilisées pour l'identification d'objets. Si nécessaire, après leur découpe à partir de la bande de support 8, les modules 6 seront protégés par un revêtement protecteur en résine ou tout autre matériau approprié, ce qui permettra d'obtenir à faible coût des étiquettes de petites dimensions. Bien entendu, les modules peuvent également être intégrés à ou fixés sur des supports différents ou plus volumineux (clés, emballages, etc...), en fonction de l'application visée.

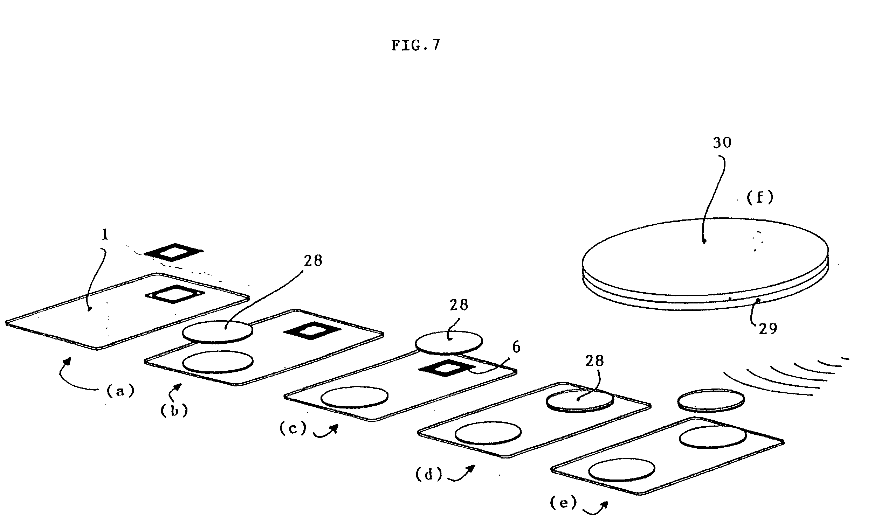

On se réfère à la figure 7. En variante intéressante du procédé de fabrication d'étiquettes, afin de profiter des économies d'échelle et des lignes de fabrication de cartes sans contact tout en utilisant des modules 6 selon l'invention, il est également possible de fabriquer des étiquettes électroniques selon un procédé comprenant uniquement l'étape consistant à découper un module électronique 6 tel que décrit plus haut, à partir d'une carte sans contact 1 incorporant un tel module, de façon à laisser subsister autour du module électronique 6 un peu de matière du corps de carte, à des fins de protection du module 6. Ainsi, on obtient très facilement à partir de cartes sans contact selon l'invention, fabriquées en grand nombre, des étiquettes électroniques présentant l'épaisseur d'une carte, mais de dimensions en plan beaucoup plus faibles.

Il apparait cependant dans ce cas un inconvénient qui peut être majeur dans certaines applications: en procédant par simple découpage à partir d'une carte sans contact, l'étiquette n'est protégée d'un côté que par la protection très minime procurée sur un côté de la cavité de la carte par un voile de matière plastique d'une centaine de micromètres d'épaisseur, alors que l'autre face du module est exposée. Pour remédier à cet inconvénient, il est possible de manière judicieuse de découper dans une partie de la carte 1 représentée en Figure 7(a), qui serait de toute manière jetée, une première pièce 28 au format prévu pour l'étiquette. Puis comme représenté dans la figure 7(b), on reporte cette pièce 28 sur la face de l'étiquette montrant le module 6 apparent et non protégé. L pièce 28 est assemblée sur la carte 1 comme représnté en figure 7(d), par une technique quelconque appropriée, notamment le collage ou la soudure par ultrasons. Enfin, comme représenté en figure 7(e), on découpe à nouveau dans la carte une pièce 29 au format de la pièce 28 et au niveau de celle-ci. On obtient ainsi pour un coût minimal, une étiquette électronique 30 symétrique représentée agrandie en figure 7(f). Bien entendu, on pourrait aussi découper les pièces 28, 29 séparément pour les assembler par la suite.

Cette étiquette 30 incorpore un module 6 protégé des deux côtés, et est susceptible d'être personalisée graphiquement des deux côtés pour en faire des étiquettes utilisables dans des jeux ou toutes autres applications.

En ce qui concerne les performances des modules, cartes et étiquettes selon l'invention, les résultats théoriques et pratiques montrent que l'on obtient sur le module 6 une antenne performante pouvant fonctionner dans la gamme de fréquences de 1 à 450 Mhz.

Pour obtenir les performances de liaison recherchées pour une application donnée, il suffit d'utiliser une fréquence de modulation suffisamment élevée (13,56 Mhz par exemple) pour obtenir des performances acceptables en distance de lecture/écriture.

Si l'on considère par exemple la fréquence de 13,56 Mhz couramment utilisée dans les applications télébilletiques, les performances obtenues sont tout à fait remarquables. Une puce 7 montée par ce procédé permet d'obtenir actuellement avec l'antenne 2 associée, une distance de fonctionnement de l'ordre de 50 mm là où la même puce montée avec une bobine classique aux dimensions d'une carte permet d'atteindre environ 70 à 75 mm. Cette différence n'est pas critique dans la plupart des applications sans contact visées à l'heure actuelle. De plus, ces performances pourront être sensiblement améliorées en travaillant au niveau des circuits d'émission et de récupération d'énergie électromagnétique du module et des lecteurs externes.

Selon un exemple de réalisation pratique, les dimensions du module utilisé sont de l'ordre de 12 mm x 12 mm, mais on peut envisager des formats oblongs légèrement plus grands pour augmenter les performances, ou encore une optimisation de l'antenne du lecteur ou de la puce elle-même en ce qui concerne sa consommation, pour améliorer les performances et atteindre celles d'une antenne de plus grande taille .

Grâce au concept de l'invention, en cas d'utilisation du module 6 pour fabriquer des cartes, l'intégrité du corps de carte est conservée pendant tout le processus de fabrication. Le corps de carte peut donc aisément être utilisé de manière traditionnelle pour recevoir une piste magnétique. De plus, il pourra être imprimé par tous les procédés existants sans contraintes particulières, autres que celles connues pour la fabrication d'une carte à contact classique.

De même, le choix du matériau du corps de carte est tout à fait libre: il permettra donc de s'adapter aux besoins requis par les diverses applications envisagées.

En conséquence, l'invention permet de résoudre d'un trait tous les inconvénients précités liés à la fabrication de modules sans contact pour cartes sans contact, et notamment celui du coût, de l'encombrement, de l'impression, de la compatibilité avec l'embossage ou la réalisation d'une piste magnétique. Les faibles dimensions de l'antenne induisent des avantages comparables en cas de fabrication d'étiquettes électroniques qui ne sont pas tributaires de la forme d'un corps de carte.

L'intérêt économique de l'invention est incontestable: elle permet de réaliser sur les mêmes chaînes de fabrication, des modules électroniques à antenne intégrée, des étiquettes électroniques et des cartes sans contact fonctionnelles, à une fraction du coût actuel constaté dans les procédés utilisés pour la production de cartes ou d'étiquettes sans contact, et ceci à toutes les étapes de fabrication.

D'autres avantages annexes liés au module, à l'étiquette électronique et à la carte sans contact selon l'invention et à leurs procédés de fabrication résident dans le fait qu'il n'y a pas de manipulation de bobine d'antenne, ni de soudure à l'étain, de positionnement précis de la bobine, ou d'impression avant encartage.

## Revendications

**1.** Procédé de fabrication d'un objet portable à module électronique sans contact; ce procédé comportant les étapes prévoyant de : réaliser le module (6) sur un substrat de support (3, 8), en : recevant sur le substrat (3, 8) un microcircuit électronique (7) ; connectant ce rnicrocircuit (7) à une antenne (2) **; caractérisé en ce qu'**il comporte les étapes prévoyant de : réaliser l'antenne (2) avec des spires directement sur ou dans le substrat (3, 8) et sensiblement dans les même plan que ce substrat (3, 8) ; découper à partir du substrat (3, 8), un premier élément (29) incorporant le module (6), la découpe de ce module étant donnée pour avoir une forme donnée (8) qui laisse subsister de la matière du substrat (3, 8) autour du module ; découper à partir d'un substrat (3, 8), un second élément (28). de même forme (8) que le premier (29); ensuite assembler ces premier et second éléments (28 ; 29), de façon que le module (6) soit incorporé entre les éléments et protégé par la matière du substrat (3, 8) autour du module (6).

2. Procédé selon la revendication 1, **caractérisé en ce que** le substrat (3, 8) des premier et / ou second éléments (28 ; 29) est un corps (3) de carte (1).

3. Procédé selon la revendication 1, **caractérisé en ce que** le substrat (3, 8) des premier et / ou second éléments (28 ; 29) est une bande (8) de film flexible (10), par exemple pour la fabrication d'une étiquette électronique.

4. Procédé selon la revendication 1, **caractérisé en ce que** le substrat (3, 8) des premier et / ou second éléments (28 ; 29) est une grille, par exemple pour la fabrication d'une étiquette électroniques.

5. Procédé selon l'une des revendications 1 à 4, **caractérisé en ce que** le substrat(3, 8) des premier et second éléments (28 ; 29) est le même (1,10), par exemple pour la fabrication d'une étiquette électronique.

6. Procédé selon l'une des revendications 1 à 5, **caractérisé en ce que** la réalisation de l'antenne (2) directement sur ou dans le substrat (3, 8) et sensiblement dans son plan est effectuée par gravure photochimique du motif d'antenne, par exemple le substrat est une grille métallique et l'antenne (2) est réalisée dans cette grille.

7. Procédé selon l'une des revendications 1 à 5, **caractérisé en ce que** la réalisation de l'antenne (2) directement sur le substrat (3, 8) et sensiblement dans son plan est effectuée par dépôt de matière métallique, par exemple par impression.

8. Procédé selon l'une des revendications 1 à 7, **caractérisé en ce que** les découpes des premier et second éléments (28 ; 29) sont effectuées de sorte que la plus grande dimension du module (6) est de l'ordre de 5 à 15 mm, par exemple pour la fabrication d'une étiquette électronique.

9. Procédé selon l'une des revendications 1 à 8, **caractérisé en ce que** l'antenne (2) est constituée par une spirale de dimensions extérieures de l'ordre de 5 à 15 mm, de préférence de l'ordre de 12 mm, dont des borne. d'extrémités (11,12) sont reliées à des plots de contact (13,14) du microcircuit (7), par exemple pour la fabrication d'une étiquette électronique.

10. Procédé selon l'une des revendications 1 à 9, **caractérisé en ce que** l'antenne (2) est en spirale conductrice et comporte entre environ 6 et environ 50 spires possédant une largeur sensiblement dans le plan du substrat (3, 8) de l'ordre de 50 à 300 µm, l'espacement entre deux spires contiguës étant de l'ordre de 50 à 200 pm, par exemple pour la fabrication d'une étiquette électronique.

11. Procédé selon l'une des revendications 1 à 10, **caractérisé en ce que** la spirale est de formé extérieure sensiblement circulaire, de diamètre extérieur de l'ordre de 5 à 15 mm et notamment d'environ 12 mm, par exemple pour la fabrication d'une étiquette électronique.

12. Procédé selon l'une des revendications 1 à 10, **caractérisé en ce que** la spirale est de forme extérieure sensiblement carrée, de côté extérieur de l'ordre de 5 à 15 mm, et de préférence d'environ 12 mm, par exemple pour la fabrication d'une étiquette électronique.

13. Procédé selon l'une des revendications 1 à 10, **caractérisé en ce que** la spirale est de forme extérieure sensiblement ovale, présentant une dimension de l'ordre de 15 mm dite plus grande dimension, et une dimension de l'ordre de 5 mm dite plus petite dimension, par exemple pour la fabrication d'une étiquette électronique.

14. Procédé selon l'une des revendications 1 à 13, **caractérisé en ce que** le microcircuit (7) est disposé au centre de l'antenne (2) et du même coté du module (6) que l'antenne, des bornes de connexion (11,12) de l'antenne étant reliées à des plots de contact (13,14) correspondants respectifs du module (6) ou du microcircuit (7) par l'intermédiaire de fils conducteurs (15).

15. Procédé selon l'une des revendications 1 à 13, **caractérisé en ce que** le microcircuit (7) est disposé du même côté que l'antenne (2) et à cheval sur les spires de celle-ci, des bornes de connexion (11,12) de l'antenne étant reliées à des plots de contact (13,14) correspondants respectifs du module (6) ou du microcircuit (7) par intermédiaire de fils conducteurs (15), et un isolant (16) étant interposé entre le microcircuit (7) et au moins la zone de l'antenne sous le microcircuit.

16. Procédé selon l'une des revendications 1 à 13, **ca-**

**ractérisé en ce que** le microcircuit (7) est disposé du côté du module (6) dépourvu d'antenne, des bornes de connexion (11,12) de l'antenne étant reliées à des plots de contact (13,14) correspondants respectifs du module (6) ou du microcircuit (7) par intermédiaire de fils conducteurs (15) traversant des puits (23) aménagés dans le substrat (3, 8) au niveau de ces bornes de connexion (11,12).

17. Procédé selon l'une des revendications 1 à 16, **caractérisé en ce qu'**un condensateur d'accord (17) est connecté en parallèle aux bornes (11,12) de l'antenne aux plots de contact (13,14) du microcircuit (7), la valeur du condensateur (17) étant choisie de manière à obtenir une fréquence de fonctionnement du module (6) située dans une plage de l'ordre de 1 MHz à 450 MHz.

18. Procédé selon la revendication 17, **caractérisé en ce que** le condensateur (17) a une valeur de l'ordre de 12 à 180 picoFarad, et **en ce que** la fréquence de fonctionnement du module est d'environ 13,56 MHz.

19. Procédé selon la revendication 17, **caractérisé en ce que** le condensateur (17) a une valeur de l'ordre de 30 à 500 picoFarad, et **en ce que** la fréquence de fonctionnement du module est d'environ 8,2 MHz.

20. Procédé selon l'une des revendications 17 à 19, **caractérisé en ce que** le condensateur d'accord (17) est obtenu par dépôt de silicium oxydé sur la surface du microcircuit (7), préalablement revêtu d'un isolant (16).

21. Procédé selon l'une des revendications 1 à 4, **caractérisé en ce qu'**il comporte sur une face du support (3, 8) une antenne (2) connectée au microcircuit (7), et sur l'autre face du support (10), des contacts (26) apparents et également connectés au microcircuit (7), de façon à obtenir une objet portable dit carte hybride pouvant être lue et écrite par l'intermédiaire des contacts (26) et / ou de l'antenne (2).

22. Procédé selon l'une des revendications 1 à 4, **caractérisé en ce que** l'objet est une étiquette qui est rendue solidaire d'un objet à identifier, par fixation ou intégration du support (3, 8) du module (6) sur ou dans cet objet à . identifier.

**Claims**

1. A method of manufacturing a portable object with a contactless electronic module; this method comprising the steps making provision for: producing the module (6) on a supporting substrate (3, 8), by: receiving on the substrate (3, 8) an electronic microcircuit (7); connecting this microcircuit (7) to an antenna (2); **characterised in that** it comprises the steps making provision for: producing the antenna (2) with turns directly on or in the substrate (3, 8) and substantially in the same plane as this substrate (3, 8); cutting from the substrate (3, 8) a first element (29) incorporating the module (6), the cutting of this module being done so as to have a given shape (8) which leaves the material of the substrate (3, 8) around the module; cutting from a substrate (3, 8) a second element (28) with the same shape (8) as the first (29); next assembling these first and second elements (28; 29) so that the module (6) is incorporated between the elements and protected by the material of the substrate (3, 8) around the module (6).

2. A method according to Claim 1, **characterised in that** the substrate (3, 8) of the first and/or second elements (28; 29) is a body (3) of a card (1).

3. A method according to Claim 1, **characterised in that** the substrate (3, 8) of the first and/or second elements (28; 29) is a strip (8) of flexible film (10), for example for manufacturing an electronic label.

4. A method according to Claim 1, **characterised in that** the substrate (3, 8) of the first and/or second elements (28; 29) is a grille, for example for manufacturing an electronic label.

5. A method according to one of Claims 1 to 4, **characterised in that** the substrate (3, 8) of the first and second elements (28; 29) is the same (1, 10), for example for manufacturing an electronic label.

6. A method according to one of Claims 1 to 5, **characterised in that** the production of the antenna (2) directly on or in the substrate (3, 8) and substantially in its plane is carried out by photochemical etching of the antenna pattern, for example the substrate is a metallic grille and the antenna (2) is produced in this grille.

7. A method according to one of Claims 1 to 5, **characterised in that** the production of the antenna (2) directly on the substrate (3, 8) and substantially in its plane is carried out by the deposition of metallic material, for example by printing.

8. A method according to one of Claims 1 to 7, **characterised in that** the cuttings of the first and second elements (28; 29) are carried out so that the largest dimension of the module (6) is around 5 to 15 mm, for example for manufacturing an electronic label.

9. A method according to one of Claims 1 to 8, **characterised in that** the antenna (2) consists of a spiral with external dimensions of around 5 to 15 mm, preferably around 12 mm, the end terminals (11, 12) of which are connected to contact pins (13, 14) of the microcircuit (7), for example for manufacturing an electronic label.

10. A method according to one of Claims 1 to 9, **characterised in that** the antenna (2) is made from a conductive spiral and comprises between approximately 6 and approximately 50 turns having a width substantially in the plane of the substrate (3, 8) of around 50 to 300 µm, the spacing between two contiguous turns being around 50 to 200 µm, for example for manufacturing an electronic label.

11. A method according to one of Claims 1 to 10, **characterised in that** the spiral has a substantially circular external shape, with an outside diameter of around 5 to 15 mm and in particular around 12 mm, for example for manufacturing an electronic label.

12. A method according to one of Claims 1 to 10, **characterised in that** the spiral has a substantially square external shape, with an outer side of around 5 to 15 mm, and preferably around 12 mm, for example for manufacturing an electronic label.

13. A method according to one of Claims 1 to 10, **characterised in that** the spiral has a substantially oval external shape, having a dimension of around 15 mm, referred to as the largest dimension, and a dimension of around 5 mm referred to as the smallest dimension, for example for manufacturing an electronic label.

14. A method according to one of Claims 1 to 13, **characterised in that** the microcircuit (7) is disposed at the centre of the antenna (2) and on the same side of the module (6) as the antenna, connection terminals (11, 12) for the antenna being connected to respective corresponding contact pins (13, 14) of the module (6) or microcircuit (7) by means of conductive wires (15).

15. A method according to one of Claims 1 to 13, **characterised in that** the microcircuit (7) is disposed on the same side as the antenna (2) and straddling the turns thereof, the connection terminals (11, 12) of the antenna being connected to respective corresponding contact pins (13, 14) of the module (6) or microcircuit (7) by means of conductive wires (15), and an insulant (16) being interposed between the microcircuit (7) and at least the area of the antenna under the microcircuit.

16. A method according to one of Claims 1 to 13, **char-**

**acterised in that** the microcircuit (7) is disposed on the side of the module (6) with no antenna, connection terminals (11, 12) of the antenna being connected to respective corresponding contact pins (13, 14) on the module (6) or microcircuit (7) by means of conductive wires (15) passing through wells (23) provided in the substrate (3, 8) at these connection terminals (11, 12).

17. A method according to one of Claims 1 to 16, **characterised in that** a tuning capacitor (17) is connected in parallel with the terminals (11, 12) of the antenna to the contact pins (13, 14) of the microcircuit (7), the value of the capacitor (17) being chosen so as to obtain an operating frequency of the module (6) situated in a range from around 1 MHz to 450 MHz.

18. A method according to Claim 17, **characterised in that** the capacitor (17) has a value of around 12 to 180 picofarads, and **in that** the operating frequency of the module is approximately 13.56 MHz.

19. A method according to Claim 17, **characterised in that** the capacitor (17) has a value of around 30 to 500 picofarads, and **in that** the operating frequency of the module is approximately 8.2 MHz.

20. A method according to one of Claims 17 to 19, **characterised in that** the tuning capacitor (17) is obtained by depositing oxidised silicon on the surface of the microcircuit (7), previously coated with an insulant (16).

21. A method according to one of Claims 1 to 4, **characterised in that** it comprises, on one face of the support (3, 8), an antenna (2) connected to the microcircuit (7) and, on the other face of the support (10), visible contacts (26) also connected to the microcircuit (7), so as to obtain a portable object known as a hybrid card which can be read and written to by means of the contacts (26) and/or the antenna (2).

22. A method according to one of Claims 1 to 4, **characterised in that** the object is a label which is secured to an object to be identified, by fixing or integration of the support (3, 8) of the module (6) on or in this object to be identified.

**Patentansprüche**

1. Fertigungsverfahren für einen tragbaren kontaktlosen Gegenstand mit elektronischem Modul; dieses Verfahren besteht aus Schritten, in denen vorgesehen ist: das Modul (6) auf einer Trägersubstrat (3,8) anzufertigen, indem auf dem Substrat (3,8) ein elektronischer Mikroschaltkreis (7) befestigt wird und dieser Mikroschaltkreis (7) an eine Antenne (2) angeschlossen wird; **gekennzeichnet dadurch, dass** Schritte vorgesehen sind: in denen die Antenne (2) mit Windungen direkt auf oder im Substrat (3,8) und deutlich in der gleichen Ebene wie dieses Substrat (3,8) angefertigt wird; aus dem Substrat (3, 8) ein erstes Element (29) ausgeschnitten wird, welches das Modul (6) enthält, wobei das Ausschneiden dieses Moduls deshalb erfolgt, um eine bestimmte Form (8) zu erhalten, so dass das Material des Substrats (3,8) um das Modul bestehen bleibt; aus einem Substrat (3,8) ein zweites Element (28) mit der gleichen Form (28) wie das erste (29) ausgeschnitten wird; anschließend das erste und das zweite Element (28, 29) zusammengesetzt werden, so dass das Modul (6) zwischen die Elemente eingesetzt wird und durch das Material des Substrats (3,8) um das Modul herum (6) geschützt wird.

2. Verfahren gemäß Anspruch 1, **gekennzeichnet dadurch, dass** das Substrat (3,8) des ersten und/ oder des zweiten Elements (28, 29) der Körper (3) einer Karte (1) ist.

3. Verfahren gemäß Anspruch 1, **gekennzeichnet dadurch, dass** dieses Substrat (3,8) des ersten und/oder zweiten Elements (28, 29) ein Streifen (8) einer flexiblen Folie (10) ist, wie sie z.B. für die Herstellung eines elektronischen Etiketts verwendet wird.

4. Verfahren gemäß Anspruch 1, **gekennzeichnet dadurch, dass** das Substrat (3,8) des ersten und/ oder zweiten Elements (28, 29) ein Gitter ist, wie es z.B. für die Herstellung eines elektronischen Etiketts verwendet wird.

5. Verfahren gemäß einem der Ansprüche 1 bis 4, **gekennzeichnet dadurch, dass** das Substrat (3,8) des ersten und zweiten Elements (28, 29) das gleiche ist (1, 10), wie es z.B. für die Herstellung eines elektronischen Etiketts verwendet wird.

6. Verfahren gemäß einem der Ansprüche 1 bis 5, **gekennzeichnet dadurch, dass** die Herstellung der Antenne (2) direkt auf oder im Substrat (3, 8) und deutlich in der gleichen Ebene durch photochemische Gravur des Antennenmotivs erfolgt. Das Substrat kann beispielsweise ein Metallgitter sein und die Antenne (2) in diesem Gitter angefertigt werden.

7. Verfahren gemäß einem der Ansprüche 1 bis 5, **gekennzeichnet dadurch, dass** die Anfertigung der Antenne (2) direkt auf dem Substrat (3, 8) und deutlich in der gleichen Ebene durch Auftragen einer Metallschicht erfolgen kann, zum Beispiel durch Druck.

8. Verfahren gemäß einem der Ansprüche 1 bis 7, **gekennzeichnet dadurch, dass** die Zuschnitte des ersten und des zweiten Elements (28, 29) so erfolgen, dass das Modul (6) höchstens 5 bis 15 mm groß ist, wie z.B. bei der Herstellung eines elektronischen Etiketts.

9. Verfahren gemäß einem der Ansprüche 1 bis 8, **gekennzeichnet dadurch, dass** die Antenne (2) aus einer Spirale besteht, deren Windungen zwischen 5 bis 15 mm groß sind, vorzugsweise aber 12 mm, und deren Klemmen an den Enden (11, 12) mit den Kontakten (13, 14) des Mikroschaltkreises (7) verbunden sind, wie z.B. bei der Herstellung eines elektronischen Etiketts.

10. Verfahren gemäß einem der Ansprüche 1 bis 9, **gekennzeichnet dadurch, dass** die Antenne (2) eine leitfähige Spirale ist und etwa zwischen 6 und 50 Windungen aufweist mit einer Breite deutlich in der Ebene des Substrats (3, 8) von 50 bis 300 μm, wobei der Abstand zwischen zwei aneinandergrenzenden Windungen 50 bis 200 μm beträgt, wie z.B. bei der Herstellung eines elektronischen Etiketts.

11. Verfahren gemäß einem der Ansprüche 1 bis 10, **gekennzeichnet dadurch, dass** die Spirale eine deutlich runde Außenform mit einem Außendurchmesser von 5 bis 15 mm, vorzugsweise aber 12 mm hat, wie z.B. bei der Herstellung eines elektronischen Etiketts.

12. Verfahren gemäß einem der Ansprüche 1 bis 10, **gekennzeichnet dadurch, dass** die Spirale eine deutlich quadratische Außenform mit einer Außenseite zwischen 5 und 15 mm, vorzugsweise aber 12 mm hat, wie z.B. bei der Herstellung eines elektronischen Etiketts.

13. Verfahren gemäß einem der Ansprüche 1 bis 10, **gekennzeichnet dadurch, dass** die Spirale eine deutlich ovale Außenform mit einer maximalen Größe von 15 mm und einer minimalen Größe von 5 mm hat, wie z.B. bei der Herstellung eines elektronischen Etiketts.

14. Verfahren gemäß einem der Ansprüche 1 bis 13, **gekennzeichnet dadurch, dass** der Mikroschaltkreis (7) in die Mitte der Antenne (2) positioniert wird, auf der gleichen Seite des Moduls (6) wie die Antenne, wobei die Kontaktklemmen (11, 12) der Antenne mittels Leitungsdrähten (15) an die Kontakte (13, 14) des Moduls (6) oder des Mikroschaltkreises (7) angeschlossen werden.

15. Verfahren gemäß einem der Ansprüche 1 bis 13, **gekennzeichnet dadurch, dass** sich der Mikroschaltkreis (7) auf der gleichen Seite wie die Antenne (2) auf den Windungen derselben befindet, wobei die Kontaktklemmen (11, 12) der Antenne über Leitungsdrähte (15) an die Kontakte (13, 14) des Moduls (6) oder des Mikroschaltkreises (7) angeschlossen werden und eine Isolation (16) zwischen den Mikroschaltkreis (7) und zumindest den Antennenbereich unter dem Mikroschaltkreis eingefügt wird.

16. Verfahren gemäß einem der Ansprüche 1 bis 13, **gekennzeichnet dadurch, dass** der Mikroschaltkreis (7) an der Seite des Moduls (6) ohne Antenne positioniert wird, wobei die Kontaktklemmen (11, 12) der Antenne über Leitungsdrähte (15) an die Kontakte (13, 14) des Moduls (6) oder des Mikroschaltkreises (7) angeschlossen werden, die in Höhe der Kontaktklemmen (11, 12) durch im Substrat (3, 8) angebrachte Löcher (23) gezogen werden.

17. Verfahren gemäß einem der Ansprüche 1 bis 10, **gekennzeichnet dadurch, dass** ein Abstimmkondensator (17) parallel zu den Klemmen (11, 12) der Antenne an die Kontakte (13, 14) des Mikroschaltkreises (7) angeschlossen wird, wobei der Wert des Kondensators (17) so gewählt wird, dass eine Funktionsfrequenz des Moduls (6) in einem Bereich zwischen 1 MHz und 450 MHz erzielt wird.

18. Verfahren gemäß Anspruch 17, **gekennzeichnet dadurch, dass** der Kondensator (17) einen Wert zwischen 12 und 180 picoFarad hat und die Funktionsfrequenz des Moduls bei 13,56 MHz liegt.

19. Verfahren gemäß Anspruch 17, **gekennzeichnet dadurch, dass** der Kondensator (17) einen Wert zwischen 30 und 500 picoFarad hat und die Funktionsfrequenz des Moduls bei 8,2 MHz liegt.

20. Verfahren gemäß einem der Ansprüche 17 bis 19, **gekennzeichnet dadurch, dass** der Abstimmkondensator (17) durch den Auftrag von oxydiertem Silizium auf der Oberfläche des zuvor mit einer Isolierung (16) versehenen Mikroschaltkreises (7) erhalten wird.

21. Verfahren gemäß einem der Ansprüche 1 bis 4, **gekennzeichnet dadurch, dass** er an einer Trägerfläche (3, 8) eine Antenne (2) aufweist, die an den Mikroschaltkreis (7) angeschlossen ist, und auf der anderen Trägerseite (10) sichtbare Kontakte (26), die ebenfalls an den Mikroschaltkreis (7) angeschlossen sind, so dass man einen tragbarer Gegenstand erhält, eine sogenannte Hybridkarte, die über Kontakte (26) und/oder die Antenne (2) gelesen und beschrieben werden kann.

22. Verfahren gemäß einem der Ansprüche 1 bis 4, **gekennzeichnet dadurch, dass** der Gegenstand ein Etikett ist, das mit einem zu identifizierenden Gegenstand durch Befestigung oder Einbau des Trägers (3, 8) des Moduls (6) auf oder in diesen zu identifizierenden Gegenstand verbunden ist.

FIG.1

FIG.2

FIG.3

fig.4A

fig.4B

fig.4C

fig.4D

FIG.4E

FIG.4F

FIG.4G

FIG.5

fig.5A

fig.5B

fig.5C

fig.5D

FIG.6

FIG. 7